# DEMANDE DE BREVET EUROPEEN

(11) **EP 4 383 359 A1**
(43) Date de publication de la demande: **12.06.2024**
(21) Numéro de dépôt: 23213631.7
(22) Date de dépôt: 01.12.2023
(51) Int. Cl.: H01L 33/16, H01L 33/00, H01L 33/32, H01L 33/12, H01L 27/15, H01L 33/02, H01L 21/306

(54) **PROCÉDÉ DE POROSIFICATION DE MÉSAS (AL,IN,GA)N/(AL,IN,GA)N ET STRUCTURE RÉSULTANTE**

(30) Priorité: 05.12.2022 FR 2212783
(60) Demande divisionnaire: 24174598.3
(71) Demandeur: Commissariat à l'énergie atomique et aux énergies alternatives, 75015 Paris (FR)
(72) Inventeur: AUDIBERT, Margaux, 38054 GRENOBLE (FR); PERNEL, Carole, 38054 GRENOBLE (FR); LEVY, François, 38054 GRENOBLE (FR); MEDJAHED, Ilyes, 38054 GRENOBLE (FR)
(74) Mandataire: Cabinet Beaumont

(57) **Abrégé**

Procédé de porosification de mésas comprenant les étapes suivantes :
- fournir une structure (100) comprenant un substrat (110) recouvert de mésas (120) (Al,In,Ga)N/(Al,In,Ga)N,
le substrat (110) comprenant une couche support (114), une première couche de GaN non dopé (111), une deuxième couche de GaN dopé (112),
les mésas (120) comprenant une troisième couche de (Al,In,Ga)N fortement dopé (123) et une quatrième couche de (Al,In,Ga)N non dopé ou faiblement dopé (124),
une partie (112b) de la deuxième couche de GaN dopé (112) se prolongeant dans les mésas (120) ou une partie (123a) de la troisième couche de (Al,In,Ga)N fortement dopé (123) se prolongeant dans le substrat (110),

- plonger la structure (100) et une contre-électrode dans une solution électrolytique,
- appliquer une tension ou un courant entre la structure (100) et la contre-électrode de manière à porosifier la troisième couche (123) en (Al,In,Ga)N fortement dopé des mésas (120).

## Description

### DOMAINE TECHNIQUE

La présente invention se rapporte au domaine général des micro-écrans couleur. L'invention concerne un procédé pour porosifier des mésas (Al,In,Ga)N/(Al,In,Ga)N. L'invention concerne également une structure ainsi obtenue comprenant des mésas (Al,In,Ga)N/(Al,In,Ga)N porosifiées. L'invention trouve des applications dans de nombreux domaines industriels, et notamment dans le domaine des micro-écrans couleur à base de micro-LEDs.

### ÉTAT DE LA TECHNIQUE ANTÉRIEURE

Les micro-écrans couleurs comprennent des pixels formés de sous-pixels bleus, verts et rouges (pixels RGB). Dans la suite de la description, ces sous-pixels seront désignés plus simplement pixel par souci de concision.

Les pixels bleus et verts peuvent être fabriqués à base de matériaux nitrures et les pixels rouges à base de matériaux phosphures. Pour combiner sur le même substrat ces trois types de pixels, la technique dite de « *pick and place* » est généralement utilisée. Cependant, dans le cas des micro-écrans avec des pixels inférieurs à 10 µm, cette technique ne peut plus être utilisée à cause, non seulement, des problèmes d'alignement, mais aussi du temps nécessaire pour réaliser une telle technique à cette échelle. Pour les écrans avec un grand nombre de pixels (définition élevée), cette technique de « *pick and place* » est problématique en terme de temps. De plus il faut prélever les pixels sur des plaques *('wafer')* différents, ce qui nécessite des transferts successifs. Des techniques de transfert en parallèle peuvent également utilisées ('*mass transfert*').

Une autre solution consiste à réaliser la conversion de couleurs avec des boîtes quantiques (QD pour « *Quantum Dot »* en langue anglaise) ou des nanophosphores pompés par des µLEDs bleues issues d'une seule plaque *('wafer'),* soit reportés, soit dans une matrice monolithique (cas préféré pour les micro-écrans). Cependant, le contrôle du dépôt de ces matériaux sur des pixels de faibles dimensions est difficile et leur tenue au flux n'est pas suffisamment robuste.

Il est donc crucial de pouvoir obtenir les trois pixels RGB de façon native avec la même famille de matériaux et dont la croissance est réalisée sur le même substrat. Pour cela, l'InGaN est le matériau le plus prometteur. Ce matériau peut, en effet, théoriquement couvrir tout le spectre visible en fonction de sa concentration en indium. Les micro-LEDs bleues à base d'InGaN montrent déjà une luminance élevée, bien supérieure à leurs homologues organiques. Pour émettre à des longueurs d'onde dans le vert, les puits quantiques (PQs) de la LED doivent contenir au moins 25% d'indium et pour une émission dans le rouge, il est nécessaire d'avoir au moins 35% d'indium. Malheureusement, la qualité du matériau InGaN au-delà de 20% d'In est dégradée en raison de la faible miscibilité de l'InN dans le GaN, mais aussi en raison de la forte contrainte compressive inhérente à la croissance de la zone active InGaN sur GaN.

Il est donc essentiel de pouvoir réduire la contrainte globale dans les structures à base de GaN/InGaN.

Actuellement, une des solutions les plus prometteuses consiste à porosifier la couche de GaN, comme décrit par exemple, dans les deux articles de Pasayat et al. (Materials 2020, 13, 213 ; Appl. Phys. Lett. 116 111101 (2020)). Le procédé décrit dans ces articles comprend les étapes suivantes :
- fournir un empilement comprenant un substrat en saphir recouvert par une couche de GaN non intentionnellement dopé (GaN nid), une couche de GaN dopé Si n+ (5.10¹⁸ at/cm³) et une couche d'InGaN ou de GaN non intentionnellement dopé,
- graver partiellement l'empilement pour former les mésas GaN/InGaN ou GaN/GaN ; l'épaisseur de la couche dopée n'est gravée que partiellement pour que la couche dopée résiduelle en fond de mésa permette la polarisation de la couche dopée de toutes les mésas ('*polarisation ring'* ou polarisation bord de plaque, par exemple)
- réaliser une étape de porosification électrochimique dans une solution d'acide oxalique (0,3M), la couche de GaN dopé jouant le rôle d'anode et un fil de platine jouant le rôle de cathode.

La couche porosifiée de GaN ainsi obtenue peut permettre de faire croître une structure LED nitrure à base d'InGaN de meilleure qualité cristalline, grâce à la relaxation des mesas poreux générés.

Cependant, la qualité de la LED dépend non seulement du diamètre des pores et de la porosité de la couche de GaN porosifiée. Il est donc nécessaire de pouvoir porosifier de manière homogène toutes les mésas d'une même plaque.

Il est également possible d'avoir une couche commune à toutes les mésas dans ces empilements. L'étape de porosification est alors réalisée en polarisant cette couche commune avec un potentiel anodique.

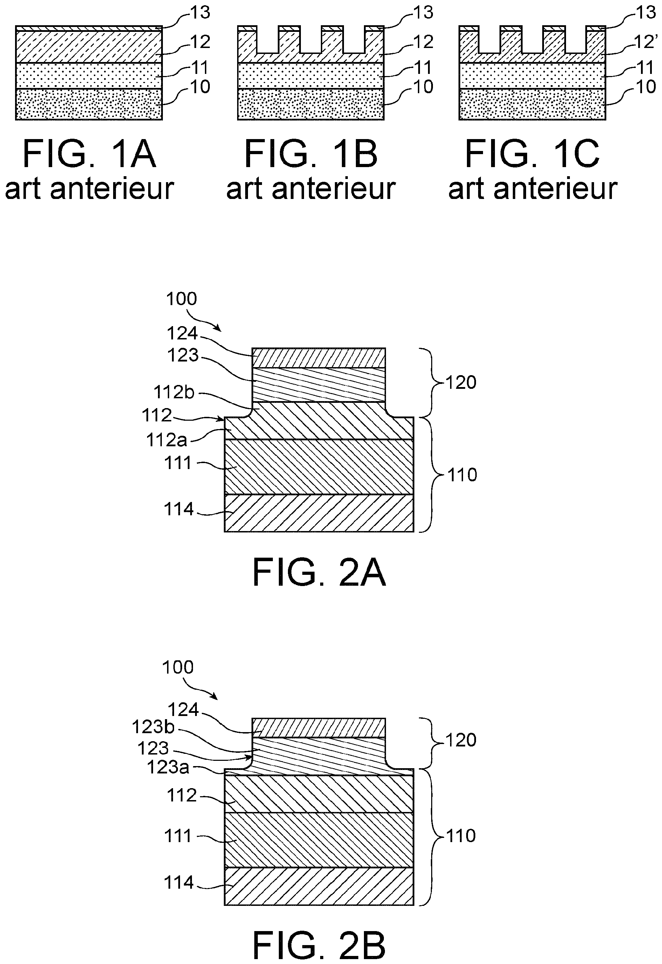

Par exemple, les figures 1A à 1C représentent différentes étapes d'un tel procédé. Plus particulièrement, le procédé comprend les étapes suivantes :
- fournir un empilement comprenant successivement une couche support 10, une couche GaN non intentionnellement dopé 11, une couche GaN dopé ou fortement dopé 12, une couche d'InGaN ou de GaN nid 13 (figure 1A),
- structurer des mésas dans cet empilement, les mésas comprenant la couche d'InGaN ou de GaN nid 13 et une partie de la couche GaN dopé ou fortement dopé 12 (figure 1B), l'autre partie de la couche GaN dopé jouant le rôle de couche commune aux mésas,
- plonger la structure obtenue dans une solution électrolytique et appliquer une tension entre la couche GaN dopé ou fortement dopé 12 et une contre-électrode, moyennant quoi on obtient une couche GaN porosifiée 12' (figure 1C).

Il est connu que les couches d'InGaN nid ont des défauts intrinsèques ('V-pits'), ce qui facilite la porosification des mésas car la solution électrolytique peut s'infiltrer à partir de cette couche supérieure 13 des mésas jusqu'à la couche dopée ou fortement dopée 12 à travers ces défauts en même temps que par les flancs de la couche dopée ou fortement dopée des mésas 12.

Cependant, les couches de GaN nid ne présentent pas de tels défauts : ce sont des couches denses. Ainsi, dans la configuration GaN/GaN, la couche dopée ou fortement dopée des mésas 12 se porosifie à partir des flancs de mésas vers le centre des mésas. Cette couche ne se porosifie pas entièrement jusqu'au centre des mésas. Des effets bord/centre de la plaque *('wafer')* sont observés, par exemple sur des plaques 2 pouces. Cet effet peut être dû à la dégradation de la conductivité latérale de la couche dopée résiduelle de fond de mésa, la polarisation se faisant par la périphérie de la plaque *('wafer')* d'où l'effet bord / centre de la plaque.

Il existe donc un réel besoin d'avoir un procédé permettant de porosifier entièrement les mésas et de limiter les effets bord centre sur les plaques, notamment sur des plaques de 2 pouces (5,08cm) et d'autant plus sur des plaques de plus grandes dimensions (200mm et 300mm).

### EXPOSÉ DE L'INVENTION

Un but de la présente invention est de proposer un procédé de porosification de mésas (Al,In,Ga)N/(Al,In,Ga)N permettant de porosifier non seulement tout le volume de la couche de GaN dopé des mésas, mais aussi de porosifier de manière identique (ou homogène) toutes les mésas sur la plaque ('wafer'), qu'elles soient en bord ou au centre de la plaque, le procédé devant être avantageusement utilisable même pour de grands substrats (typiquement sur des substrats d'au moins 5 cm et de préférence d'au moins 10cm de diamètre).

Pour cela, la présente invention propose un procédé de porosification de mésas (Al,In,Ga)N /(Al,In,Ga)N comprenant les étapes suivantes :
a) fournir une structure comprenant un substrat de base recouvert de mésas (Al,In,Ga)N/(Al,In,Ga)N,
   le substrat de base comprenant une couche support, une première couche de GaN non dopé, une deuxième couche de GaN dopé,
   les mésas (Al,In,Ga)N/(Al,In,Ga)N comprenant une troisième couche de (Al,In,Ga)N fortement dopé et une quatrième couche de (Al,In,Ga)N non dopé ou faiblement dopé,
   une partie de la deuxième couche de GaN dopé se prolongeant dans les mésas ou une partie de la troisième couche de (Al,In,Ga)N fortement dopé se prolongeant dans le substrat de base,
b) relier électriquement la structure (par exemple au niveau de la deuxième couche dopée, de la troisième couche fortement dopée ou de la quatrième couche faiblement dopée) et une contre-électrode à un générateur de tension ou de courant,
c) plonger la structure et la contre-électrode dans une solution électrolytique,
d) appliquer une tension ou un courant entre la structure et la contre-électrode de manière à porosifier la troisième couche de (Al,In,Ga)N fortement dopé des mésas.

L'invention se distingue fondamentalement de l'art antérieur par la présence d'un bicouche comprenant deux couches à base de GaN dopé ayant des dopages différents (la deuxième couche en GaN dopé et la troisième couche en (Al,In,Ga)N fortement dopé). Le bicouche est positionné entre la première couche de GaN non dopé du substrat et la quatrième couche de (Al,In,Ga)N non dopé ou faiblement dopé des mésas.

La deuxième couche a un taux de dopage inférieur à celui de la troisième couche, et peut servir à réaliser le contact électrique. Grâce à une sélectivité de porosification en fonction du dopage, la deuxième couche n'est pas porosifiée pendant l'étape d) et reste intègre jusqu'à la fin du processus de porosification des mésas, ce qui permet de porosifier toutes les mésas en volume quelles que soient leur position dans la structure. Il est ainsi possible de porosifier la troisième couche de (Al,In,Ga)N fortement dopé sans trop augmenter l'épaisseur de l'empilement ('*stack*'), notamment dans le cas d'un substrat en silicium.

Avantageusement, pour la deuxième couche, on choisira un dopage suffisamment faible pour que la couche ne soit pas porosifiée, tout en étant suffisamment élevé pour assurer la conduction électrique. Par exemple, le taux de dopage de la deuxième couche de GaN dopé est inférieur à 5.10¹⁸at/cm³, de préférence compris entre 5.10¹⁷at/cm³ et 3.10¹⁸at/cm³, encore plus préférentiellement entre 5.10¹⁷at/cm³ et 2.10¹⁸at/cm³. Un tel taux dopage est par exemple obtenu avec un dopage au silicium. Il est également possible d'avoir un dopage avec du germanium. Le dopage pourra alors être plus élevé, par exemple jusqu'à 5.10¹⁸at/cm³, voire jusqu'à 1,5.10¹⁹ at/cm³.

Avantageusement, le dopage de la troisième couche est nettement supérieur à celui de la deuxième couche pour obtenir une sélectivité vis-à-vis de la porosification. Plus la différence de dopage entre la deuxième couche dopée et la troisième couche très dopée est forte et plus la sélectivité du procédé de porosification est bonne. Les valeurs de dopage adéquates dépendent du potentiel appliqué pour la sélectivité de porosification. Par exemple, le taux de dopage de la troisième couche en (Al,In,Ga)N fortement dopé est compris entre 5.10¹⁸at/cm³ et 2.10¹⁹at/cm³, de préférence entre 6.10¹⁸at/cm³ et 2.10¹⁹at/cm³, encore plus préférentiellement entre 8.10¹⁸at/cm³ et 1,5.10¹⁹at/cm³, de manière encore plus préférentielle entre 8.10¹⁸at/cm³ et 1.10¹⁹at/cm³par exemple avec un dopage Si ou Ge. Il est possible d'avoir des taux de dopage jusqu'à 1.10²⁰at/cm³ voire 1.10²¹at/cm³ avec un dopage au Ge.

Selon un mode de réalisation particulièrement avantageux, la structure comprend en outre une couche additionnelle de GaN fortement dopé disposée entre la première couche de GaN non dopé et la troisième couche en (Al,In,Ga)N dopé. Ici, on comprend que le niveau de dopage du GaN fortement dopé de la couche additionnelle est supérieur à celui de la première couche de GaN non dopé et à celui de la troisième couche en (Al,In,Ga)N dopé. On a ainsi un tri-couche comprenant une couche additionnelle de GaN fortement dopé recouverte par la deuxième couche dopée et la troisième couche fortement dopée à porosifier. Le tricouche est positionné entre la première couche de GaN non dopé du substrat et la quatrième couche de (Al,In,Ga)N non dopé ou faiblement dopé des mésas.

Dans la mesure où la deuxième couche dopée recouvre entièrement la couche additionnelle, elle assure la protection de la couche additionnelle fortement dopée sous-jacente de toute porosification, et assure également la prise de contact. Avantageusement, cette couche est fine (typiquement entre 200nm et 1µm, préférentiellement entre 400 et 700nm). Cette couche est, avantageusement, la plus fine possible tout en restant bien couvrante pour éviter l'infiltration de l'électrolyte et donc la consommation de la couche additionnelle sous-jacente fortement dopée lors de l'étape d).

La couche additionnelle fortement dopée assure la conduction latérale des charges dans la structure. Par exemple, le taux de dopage de la couche additionnelle de GaN fortement dopé est compris entre 5.10¹⁸at/cm³ et 2.10¹⁹at/cm³, de préférence entre 5.10¹⁸at/cm³ et 1,5.10¹⁹at/cm³, encore plus préférentiellement entre 8.10¹⁸at/cm³ et 1.10¹⁹at/cm³. Avantageusement, cette couche est épaisse (typiquement entre 0,5 µm et 5µm et de préférence entre 1 et 2µm). Des épaisseurs les plus élevées pourront être obtenues sur saphir. On obtient ainsi une couche enterrée très conductrice grâce à un fort taux de dopage et une épaisseur de couche importante. Le couple épaisseur dopage sera adapté pour avoir une conduction latérale suffisante. Lors de l'étape d), la conduction se fait *via* cette couche additionnelle enterrée très dopée. Comme elle est très conductrice, elle limite les effets bord / centre.

Les charges passent à travers la deuxième couche dopée puis se retrouvent sur la couche additionnelle très dopée qui joue alors le rôle d'autoroute de conduction et alimente toutes les mésas présentes sur le substrat. Lors de l'étape d), la deuxième couche dopée protège la couche additionnelle fortement dopée de la porosification. Ainsi, chaque mésa est dans la même configuration électrique pour être porosifiée de façon uniforme quelles que soient la taille et la position de la mesa sur la plaque (bord ou centre).

Avantageusement, le taux de dopage de la troisième couche en (Al,In,Ga)N fortement dopé et/ou le taux de dopage de la couche additionnelle de GaN fortement dopé est compris entre 5.10¹⁸at/cm³ et 1,5.10¹⁹at/cm³.

Avantageusement, la tension appliquée lors de l'étape e) est comprise entre 3V et 15V, de préférence entre 6V et 12V, encore plus préférentiellement entre 8V et 12V, et de manière encore plus préférentielle entre 8 et 10V.

Avantageusement, la couche support est une tranche ('wafer') d'au moins 5 cm de diamètre (par exemple 2 pouces soit 5,08 cm), de préférence d'au moins 100 mm de diamètre et encore plus préférentiellement d'au moins 200mm de diamètre.

Avantageusement, la couche support est en saphir ou en silicium.

Avantageusement, la quatrième couche de (Al,In,Ga)N non dopé ou faiblement dopé est une couche de GaN.

A l'issue de l'étape d), des LEDs peuvent ensuite être formées, par exemple par épitaxie, sur les mésas pour former des pixels.

Le procédé présente de nombreux avantages :
- il est simple à mettre en oeuvre,
- il peut être appliqué sur des plaques ('wafers') de grande taille pour gérer la problématique d'uniformité de polarisation électrochimique et donc de porosification / relaxation,
- il est compatible avec l'utilisation de substrats Si (111) pour la croissance, plus sensibles à la déformation que le saphir, le fort dopage de la couche enterrée permettant de réduire son épaisseur,
- la préservation de la porosification des fonds de mesas permet une meilleure maîtrise de l'épitaxie d'InGaN, notamment en cas d'épitaxie sélective, le masque de croissance sur les fonds de mesas non poreux favorisant la mobilité des espèces vers les sites de croissance
- il peut être utilisé pour des mésas de différentes tailles y compris des mésas ayant de faibles épaisseurs.

De plus, la croissance sur de telles mésas poreuses présente les avantages suivants :
- la structuration en mésa apporte l'effet de compliance élastique y compris pendant la croissance,
- il conduit à une relaxation partielle ou totale des contraintes et diminue la polarisation piézo-électrique par comparaison à une couche contrainte de même concentration en In,
- il permet une approche dite « *bottom up* » pour la fabrication de µLED et µdisplay : la croissance des structures optiques (N, QW, P) est réalisée après pixellisation en mésa, quelle que soit la taille des pixels, et permet de s'affranchir des problèmes d'alignement comme pour le procédé « *pick and place »,*
- il n'y a pas d'impact du procédé de gravure des pixels sur l'efficacité des micro-LEDs, ce qui rend possible la réalisation de pixel micrométrique ou sub-micrométrique.

L'invention concerne également une structure obtenue selon le procédé décrit précédemment.

La structure comprend un substrat de base recouvert de mésas (Al,In,Ga)N/(Al,In,Ga)N porosifiées,
le substrat de base comprenant une couche support, une première couche de GaN non dopé, une deuxième couche de GaN dopé,
les mésas (Al,In,Ga)N/(Al,In,Ga)N comprenant une troisième couche de (Al,In,Ga)N fortement dopé et porosifié et une quatrième couche de (Al,In,Ga)N non dopé ou faiblement dopé,
une partie de la deuxième couche de GaN dopé pouvant en outre se prolonger dans les mésas.

Avantageusement, la structure comprend en outre une couche additionnelle de GaN fortement dopé disposée entre la première couche de GaN non dopé et la deuxième couche de GaN dopé.

Avantageusement, la quatrième couche de (Al,In,Ga)N non dopé ou faiblement dopé est une couche de GaN et/ou la couche support est une tranche de 2 pouces ou une tranche d'au moins 100mm de diamètre et, de préférence une tranche d'au moins 200mm de diamètre.

D'autres caractéristiques et avantages de l'invention ressortiront du complément de description qui suit.

Il va de soi que ce complément de description n'est donné qu'à titre d'illustration de l'objet de l'invention et ne doit en aucun cas être interprété comme une limitation de cet objet.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
Les Figures 1A à 1C, précédemment décrites, représentent, de manière schématique différentes étapes d'un procédé de porosification selon l'art antérieur ;
Les Figures 2A et 2B, et les Figures 3A et 3B représentent, de manière schématique et en coupe, différentes structures comprenant des mésas (Al,In,Ga)N/(Al,In,Ga)N selon différents modes de réalisation de l'invention ;

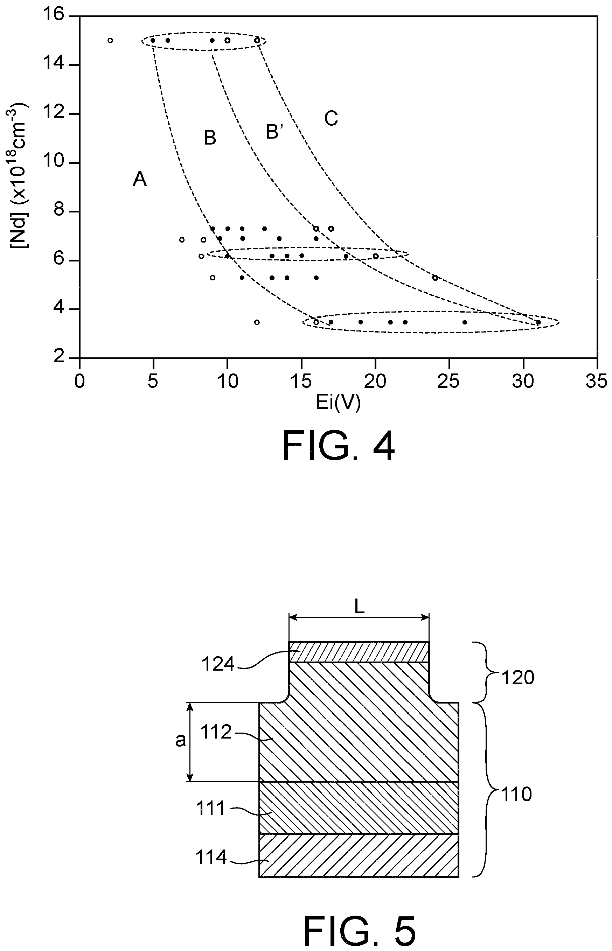

La Figure 4 est un graphique représentant différents phénomènes intervenant (pré-porosification (ou « *pre-breakdown* »), porosification, et électropolissage) lors d'une étape d'anodisation, en fonction du taux de dopage d'une couche de GaN et de la tension appliquée, selon un mode de réalisation particulier de l'invention ; la région A correspond à la région de pré-porosification (ou *'pre-breakdown'*), la région B à la région de porosification, la région B' à la région transitoire entre les régions B et C, où les pores se rejoignent et coalescent, et la région C à la région d'électropolissage ;
La Figure 5 représente, de manière schématique et en coupe, une structure comprenant des mésas (Al,In,Ga)N/(Al,In,Ga)N (en particulier GaN/GaN) utilisée à titre comparatif ;
La Figure 6 est un cliché obtenu au microscope électronique à balayage d'une mésa (Al,In,Ga)N/(Al,In,Ga)N de la structure représentée sur la figure 5 après l'étape de porosification, qui conduit à une porosification incomplète ;
Les Figures 7A et 7B sont des clichés obtenus au microscope optique en fond noir de différentes mésas (Al,In,Ga)N/(Al,In,Ga)N, en vue de dessus, de la structure représentée sur la figure 5 après l'étape de porosification, respectivement au niveau du centre et au niveau d'un bord de la structure ; la partie à gauche des figures correspond à des mésas (Al,In,Ga)N/(Al,In,Ga)N de 3 µm de largeur et la partie à droite des figures correspond à des mésas (Al,In,Ga)N/(Al,In,Ga)N de 5µm de largeur ;
La Figure 8 est un cliché obtenu au microscope optique en fond noir de mésas (Al,In,Ga)N/(Al,In,Ga)N de 3 µm de largeur (à gauche) et de mésas (Al,In,Ga)N/(Al,In,Ga)N de 5µm de largeur (à droite), en vue de dessus, après l'étape de porosification selon différents modes de réalisation particuliers de l'invention ; le cliché est pris au niveau du centre des structures (c'est-à-dire au plus loin du contact électrique qui est pris en bord de plaque, i.e. au centre qui est l'endroit où la perte de potentiel est la plus importante) ;
La Figure 9 est un cliché obtenu au microscope optique en fond noir de mésas (Al,In,Ga)N/(Al,In,Ga)N de 3µm de largeur (à gauche) et de mésas (Al,In,Ga)N/(Al,In,Ga)N de 5µm de largeur (à droite), en vue de dessus, après l'étape de porosification selon différents modes de réalisation particuliers de l'invention ; le cliché est pris au niveau du centre des structures ;
Les Figures 10A et 10B sont des clichés obtenus au microscope électronique à balayage d'une mésa (Al,In,Ga)N/(Al,In,Ga)N porosifiée selon un mode de réalisation particulier de l'invention ;
Les Figures 11A et 11B sont des simulations représentant les densités de courant dans une structure comprenant des mésas (Al,In,Ga)N/(Al,In,Ga)N lors d'une étape de porosification à 12V, selon un mode de réalisation particulier de l'invention ;

### EXPOSÉ DÉTAILLÉ DE MODES DE RÉALISATION PARTICULIERS

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

En outre, dans la description ci-après, des termes qui dépendent de l'orientation, tels que « dessus », « dessous », etc. d'une structure s'appliquent en considérant que la structure est orientée de la façon illustrée sur les figures.

Bien que cela ne soit aucunement limitatif, l'invention trouve particulièrement des applications dans le domaine des micro-écrans couleurs, et plus particulièrement pour la fabrication des pixels rouge vert bleu. Cependant, elle pourrait être utilisée dans le domaine du photovoltaïque ou encore de l'électrolyse de l'eau (« *water splitting* ») puisque, d'une part, l'InGaN absorbe dans tout le spectre visible et que, d'autre part, ses bandes de valence et de conduction sont autour du domaine de stabilité de l'eau, condition thermodynamique nécessaire à la réaction de décomposition de l'eau. L'invention peut également être intéressante pour la fabrication de LED ou de laser émettant à grande longueur d'onde.

Le procédé est particulièrement intéressant pour fabriquer des structures comprenant des mésas (Al,In,Ga)N/(Al,In,Ga)N porosifiées ayant, notamment, un pas inférieur à 30 µm.

Par (Al,In,Ga)N, on entend AIN, AIGaN, InGaN ou GaN. Par la suite, on fait plus particulièrement référence à du GaN poreux, mais avec un tel procédé, il est possible d'avoir, par exemple, de l'InGaN ou du AIGaN poreux. La couche dense en InGaN (en compression) ou la couche dense en AlGaN (en tension) va se relaxer grâce à une structure poreuse quelle que soit sa composition.

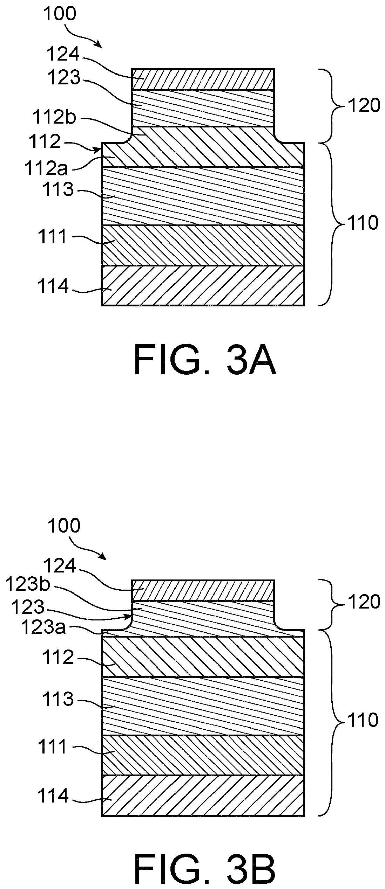

Le procédé de porosification de mésas 120 de (Al,In,Ga)N/(Al,In,Ga)N comprend les étapes suivantes :
a) fournir une structure 100 comprenant un substrat de base 110 recouvert de mésas 120 (Al,In,Ga)N/(Al,In,Ga)N (figures 2A, 2B, 3A, 3B),
   le substrat de base 110 comprenant successivement :
      - une couche support 114,
      - éventuellement une couche tampon en (AI,Ga)N, notamment dans le cas d'une couche support 114 en silicium,
      - une première couche 111 de GaN non dopé,
      - avantageusement, une couche additionnelle 113 fortement dopée,
      - une deuxième couche 112 de GaN dopé,
   les mésas 120 (Al,In,Ga)N/(Al,In,Ga)N comprenant :
      - une troisième couche 123 de (Al,In,Ga)N fortement dopé, destinée à être porosifiée et
      - une quatrième couche 124 de (Al,In,Ga)N non dopé ou faiblement dopé,
   une partie de la deuxième couche de GaN dopé se prolongeant dans les mésas ou une partie de la troisième couche de (Al,In,Ga)N fortement dopé se prolongeant dans le substrat de base,
   le fond des mésas est, de préférence, préservé de la porosification lors de l'étape d),
b) relier électriquement la structure 100 et une contre-électrode à un générateur de tension ou de courant,
c) plonger la structure 100 et la contre-électrode dans une solution électrolytique,
d) appliquer une tension ou un courant entre la deuxième couche 112 de GaN dopé et la contre-électrode de manière à porosifier la troisième couche 123 de (Al,In,Ga)N fortement dopé des mésas 120.

La structure 100 fournie à l'étape a) est, par exemple, obtenue en fournissant puis gravant localement un empilement comprenant successivement :
- une couche support 114,
- éventuellement, une couche tampon en (AI,Ga)N, notamment dans le cas d'une couche support 114 en silicium,
- une première couche 111 de nitrure de de gallium GaN non dopé,
- éventuellement, une couche additionnelle 113 de GaN fortement dopé,
- une deuxième couche 112 de GaN dopé (GaN:n),
- une troisième couche 123 en (Al,In,Ga)N fortement dopé (GaN n+ ou GaN n++), et
- une quatrième couche 124 en AIN, InGaN ou GaN (noté (Al,In,Ga)N) non intentionnellement dopé (nid) ou faiblement dopé.

De préférence, l'empilement est constitué des couches précédemment citées. Autrement dit, il ne comporte pas d'autres couches.

Selon un mode de réalisation avantageux, une première partie 112a de la deuxième couche 112 fait partie du substrat de base 110 et une deuxième partie 112b de la deuxième couche 112 fait partie des mésas 120 (comme représenté sur les figures 2A et 3A).

Les mésas 120 sont formées en gravant la quatrième couche 124, la troisième couche 123 et une première partie 112a de la deuxième couche dopée 112 (figures 2A et 3A). En arrêtant la gravure dans la couche dopée, toute la hauteur de la troisième couche n++ 123 est disponible pour la relaxation.

Chaque mésa 120 comprend successivement depuis la base : la deuxième partie 112b de la couche 112 de GaN dopé, la troisième couche 123 en (Al,In,Ga)N fortement dopé et la quatrième couche 124 de (Al,In,Ga)N non dopé ou faiblement dopé.

La première partie 112a de la deuxième couche 112 de GaN dopé protège la couche additionnelle 113 lors de l'étape de porosification. Ainsi, la couche additionnelle 113 n'est pas en contact avec la solution. La première partie de la couche GaN dopé est une couche commune à toutes les mésas.

Selon un autre mode de réalisation, les mésas 120 sont formées en gravant la quatrième couche 124 et une partie de la troisième couche 123 fortement dopée (figures 2B et 3B). La couche 123 dopée n++ n'est pas totalement gravée, préservant ainsi l'intégrité de la couche n-GaN. Ce mode de réalisation est particulièrement avantageux pour protéger la couche dopée n++ enterrée 113 (figure 3B). Une première partie 123a de la couche 123 est dans le substrat de base 110 et une deuxième partie 123b de la couche 123 fait partie des mésas 120.

La structuration de l'empilement est, par exemple, réalisé par photolithographie.

Ainsi, on obtient une structure 100 comprenant un substrat de base 110 surmonté d'une pluralité de mésas 120 en (Al,In,Ga)N/(Al,In,Ga)N.

Les mésas 120, aussi appelées élévations, sont des éléments en relief. Elles sont obtenues, par exemple, par gravure d'une couche continue ou de plusieurs couches continues superposées, de manière à ne laisser subsister qu'un certain nombre de "reliefs" de cette couche ou de ces couches. La gravure est de préférence réalisée avec un masque dur, par exemple SiO₂. Après gravure des mésas, ce masque dur est retiré par un procédé chimique humide avant porosification. Il est également possible de retirer ce masque dur après porosification, en le dégageant uniquement, dans les zones servant à la polarisation pour la polarisation électrochimique. Avantageusement, le masque est retiré avant l'étape de porosification.

De préférence, les flancs des mésas 120 sont perpendiculaires à cet empilement de couches.

La surface des mésas peut être circulaire, hexagonale, carrée ou rectangulaire.

La plus grande dimension de la surface des mésas 120 va de 500nm à 500µm. Par exemple, la plus grande dimension d'une surface circulaire est le diamètre.

L'épaisseur des mésas correspond à la dimension de la mésa perpendiculaire à l'empilement sousjacent.

L'espacement entre deux mésas 120 consécutives va de 50nm à 20µm.

Les mésas 120 peuvent avoir des dopages identiques ou différents. Plus le taux de dopage est élevé, et plus la porosification sera importante à potentiel fixe. La relaxation de la quatrième couche 124 de (Al,In,Ga)N dense dépend du taux de porosification des mésas. Ainsi, des quantités différentes d'indium pourront être intégrées lors de la ré-épitaxie d'InGaN sur la couche dense 124 (grâce à la réduction du « *compositionnal pulling effect* » (i.e. du poussage des atomes d'In vers la surface, les empêchant de s'incorporer dans la couche). On obtiendra ainsi, après épitaxie de la structure LED complète, des mésas bleues, vertes et rouges (RGB) sur un même substrat, et en une seule étape de croissance, si l'écart entre les niveaux de relaxation des mésas est suffisant.

La couche support 114 est, par exemple en saphir ou en silicium.

La couche support 114 a, par exemple, une épaisseur allant de 250µm à 2mm. L'épaisseur dépend de la nature de la couche support 114 et de ses dimensions. Par exemple, pour une couche support en saphir de 2 pouces de diamètre, l'épaisseur peut être de 350 µm. Pour une couche support en saphir de 6 pouces de diamètre, l'épaisseur peut être de 1,3mm. Pour une couche support en silicium de 200mm de diamètre, l'épaisseur peut être 1mm.

Dans le cas d'une couche support 114 en silicium, une couche tampon ('buffer') en (AI,Ga)N est, avantageusement, interposée entre la couche support 114 et la couche nid GaN 111.

La première couche 111 est une couche en GaN nid. C'est une couche non intentionnellement dopée (nid) pour ne pas être porosifiée. Par GaN non intentionnellement dopé, on entend une concentration inférieure à 5.10¹⁷at/cm³.

La première couche 111 en GaN nid a, par exemple, une épaisseur allant de 500nm à 5µm. Avantageusement, son épaisseur est entre 1 et 4 µm pour absorber les contraintes liées au désaccord de maille entre le GaN et le substrat.

La deuxième couche 112 est une couche en GaN dopé. Par GaN dopé, on entend une concentration supérieure à 5.10¹⁷ at/cm³, de préférence supérieure à 10¹⁸ at/cm³, de préférence entre 1.10¹⁸ at/cm³ et 5.10¹⁸ at/cm³.

La deuxième couche 112 en GaN a, par exemple, une épaisseur allant de 200nm à 1µm, préférentiellement entre 400 et 700nm. Elle doit être suffisamment électriquement conductrice pour pouvoir réaliser une reprise de contact sur cette couche lors de l'étape d'anodisation électrochimique. L'épaisseur minimale varie en fonction du taux de dopage. Cette couche électriquement conductrice est électriquement connectée au générateur de tension ou de courant.

La troisième couche 123 est une couche de GaN fortement dopé. Par GaN fortement dopé, on entend une concentration supérieure à 5.10¹⁸ at/cm³, de préférence supérieure à 8.10¹⁸ at/cm³, voire supérieure à 10¹⁹ at/cm³. Elle a, par exemple, un dopage dix fois plus élevé que la deuxième couche 112. Elle a une épaisseur comprise entre 200nm et 2 µm. De préférence de 500 nm à 1µm.

La quatrième couche 124 est une couche (Al,In,Ga)N non intentionnellement dopé ou faiblement dopé. Par (Al,In,Ga)N faiblement dopé, on entend un dopage entre 5.10¹⁷ at.cm³ et 2.10¹⁸ at. cm³. Par non dopé, on entend un taux de dopage inférieur à 5.10¹⁷at/cm³.

Il peut s'agir d'une couche en AIN, AIGaN, InGaN ou GaN. Elle a par exemple une épaisseur entre 10nm et 200nm, de préférence entre 50 et 200nm. Le dopage est suffisamment faible de manière à ce que cette couche soit électriquement isolante. Elle n'est pas porosifiée lors de l'étape d).

Cette couche 124 n'est pas ou peu impactée par la porosification et sert de germe pour une reprise de croissance. Cette couche 124 est continue pour assurer la qualité de la couche répitaxiée, d'une couche d'(ln,Ga)N par exemple, sur la structure.

La couche additionnelle 113 a une épaisseur comprise, par exemple, entre 500nm à 5 µm, de préférence entre 1µm et 5µm. De préférence, elle a une concentration de dopage supérieure à 8.10¹⁸ at.cm³, voire supérieure à 10¹⁹ at.cm³, par exemple de 1,5. 10¹⁹ at.cm³. La couche additionnelle 113 en GaN fortement dopé peut avoir un dopage identique ou différent de celui de la troisième en couche en GaN fortement dopé. La couche additionnelle 113 en GaN fortement dopé peut avoir une épaisseur identique ou différente de celle de la troisième en couche en GaN fortement dopé. De préférence, elle a une épaisseur supérieure à celle de la troisième couche pour assurer une bonne mobilité des charges.

Les dopages des différentes couches précitées, et notamment de la deuxième couche 112, de la troisième couche 123 et de la couche additionnelle 113, seront choisis en fonction de la tension appliquée lors de la porosification.

En particulier, ils seront choisis à partir de l'« abaque » de la figure 4. Cet « abaque » permet de définir les taux de dopage respectifs pour qu'à potentiel donné, il y ait une sélectivité entre la zone fortement dopée et la zone faiblement dopée. Pour un potentiel donné, le taux de dopage de la deuxième couche 112 doit se situer dans la région A pour que la deuxième couche 112 ne soit pas porosifiée lors de l'étape d) et le taux de dopage de la troisième couche 123 doit situer dans la région B pour que la troisième 123 soit porosifiée lors de l'étape d).

Par la suite, on décrit un dopage de type n, mais il pourrait s'agir d'un dopage de type p.

A titre illustratif et non limitatif, selon une variante de réalisation, la structure 100 peut comprendre :
- un substrat de base 110 comprenant successivement : une couche support 114 en saphir ou en silicium, éventuellement une couche tampon en (AI,Ga)N, une première couche 111 de GaN non dopé de 4µm, une première partie 112a de la deuxième couche 112 de GaN dopé de 500nm (1.10¹⁸ at/cm³),
- des mésas 120 (Al,In,Ga)N/(Al,In,Ga)N comprenant successivement : une deuxième partie 112b de la deuxième couche 112 de GaN dopé de 100nm (1.10¹⁸ at/cm³), une troisième couche 123 de GaN fortement dopé de 800 nm (1.10¹⁹ at/cm³), et une couche de nid (Al,In,Ga)N de 100nm.

Selon une autre variante de réalisation, la structure 100 peut comprendre :
- un substrat de base 110 comprenant successivement : une couche support 114 en saphir ou en silicium, éventuellement une couche tampon en (AI,Ga)N, une première couche 111 de GaN non dopé de 4µm, une couche additionnelle 113 de GaN fortement dopé de 2µm (1.10¹⁹ at/cm³), une première partie 112a de la deuxième couche 112 de GaN dopé de 500nm (1.10¹⁸ at/cm³),
- des mésas 120 (Al,In,Ga)N/(Al,In,Ga)N comprenant successivement : une deuxième partie 112b de la deuxième couche 112 de GaN dopé de 100nm (1.10¹⁸ at/cm³), une troisième couche 123 de GaN fortement dopé de 800 nm (1.10¹⁹ at/cm³), et une quatrième couche 124 de (Al,In,Ga)N nid de 100nm.

Lors de l'étape b), la structure 100 et une contre-électrode (CE) sont électriquement reliées à un générateur de tension ou de courant. Le dispositif joue le rôle d'électrode de travail (WE). Par la suite, on le dénommera générateur de tension, mais il pourrait s'agir d'un générateur de courant permettant d'appliquer un courant entre le dispositif et la contre-électrode.

La prise de contact est réalisée sur la structure 100.

En particulier, la prise de contact peut être réalisée sur le substrat de base 110. Comme représentée sur les figures 2A, 2B, 3A et 3B, la reprise de contact peut être réalisée sur la deuxième couche 112 de GaN dopé (la prise de contact est représentée par une flèche sur les figures 2A, 2B, 3A et 3B). La reprise de contact peut être faite sur le fond des mésas, au niveau de la deuxième couche 112, ce qui permet d'utiliser l'étape de gravure pour réaliser également les prises de contact.

Il est également possible de prendre contact sur une des autres couches : sur la quatrième couche 124 de (Al,In,Ga)N faiblement dopé, sur la troisième couche 123 de (Al,In,Ga)N fortement dopé ou sur la couche additionnelle 113 de GaN fortement dopé. Dans le cas d'une reprise de contact sur couche fortement dopée, son ouverture sera, avantageusement, limitée à une zone préservée de l'électrolyte.

La zone de reprise de contact peut également être surmontée d'une couche métallique afin d'améliorer le contact pour la polarisation électrochimique. Ce contact pourra être retiré après la porosification avant la reprise d'épitaxie.

La contre-électrode 500 est en un matériau électriquement conducteur, comme par exemple un métal de grande surface développée et inerte à la chimie de l'électrolyte tel qu'un grillage en platine.

Lors de l'étape c), les électrodes sont plongées dans un électrolyte, aussi appelé bain électrolytique ou solution électrolytique. L'électrolyte peut être acide ou basique. L'électrolyte est, par exemple, de l'acide oxalique. Il peut également s'agir de KOH, HF, HNO₃, NaNO₃ ou H₂SO₄.

Lors de l'étape d), on applique une tension entre la structure 100 et la contre-électrode 500. La tension peut aller de 1 à 30V par exemple. De préférence, elle est de 5 à 15V, et encore plus préférentiellement de 6 à 12V, par exemple de 8 à 10V. La tension est choisie en fonction des taux de dopage des différentes couches, afin d'obtenir la sélectivité recherchée. Elle est appliquée, par exemple, pendant une durée allant de quelques secondes à plusieurs heures. La porosification est complète lorsqu'il n'y a plus de courant à potentiel imposé. A ce moment-là, toute la structure dopée est porosifiée et la réaction électrochimique s'arrête.

L'étape d'anodisation électrochimique peut être réalisée sous lumière ultra-violette (UV).

Avantageusement, la porosification a lieu dans tout le volume de la troisième couche 123 en (Al,In,Ga)N fortement dopé.

A l'issue de l'étape de porosification, le taux de porosité de la troisième couche 123 en (Al,In,Ga)N fortement dopé est, avantageusement, d'au moins 10%. Il va de préférence de 25% à 70%, de préférence de 25% à 50%, par exemple de 45% à 50%.

La plus grande dimension (la hauteur) des pores peut varier de quelques nanomètres à quelques micromètres. La plus petite dimension (le diamètre) peut varier de quelques nanomètres à une centaine de nanomètres, en particulier de 30 à 70nm.

La porosification obtenue (taux de porosité et taille des pores) dépend du dopage de la couche et des paramètres du procédé (tension appliquée, durée, nature et concentration de l'électrolyte, post-traitement chimique ou recuit). La variation de la porosification permet de contrôler le taux d'incorporation / ségrégation. La porosification, et en particulier, la taille des pores, pourra varier ultérieurement, lors de la reprise d'épitaxie en fonction de la température appliquée.

Avantageusement, le procédé comprend une étape e) ultérieure au cours de laquelle on réalise une épitaxie sur les mésas 120, moyennant quoi on obtient une couche épitaxiée au moins partiellement relaxée, et de préférence totalement relaxée.

Le pourcentage de relaxation correspond à : Δa/a = (a_{c2}-a_{c1})/a_{c1}, avec a_{c1}, le paramètre de maille de la couche de départ sur laquelle on reprend l'épitaxie (c'est-à-dire le paramètre de maille de la couche 124), et a_{c2} le paramètre de maille de la couche relaxée.

La couche est relaxée à 100% si a_{c2} correspond au paramètre de maille du matériau massif, de même composition que la couche réépitaxiée. Lorsque a_{c1}=a_{c2}, le couche est dite contrainte.

Par partiellement relaxée, on entend un pourcentage de relaxation supérieur à 50%.

La reprise d'épitaxie peut servir, par exemple, pour former des LED ré-épitaxiées.

La reprise d'épitaxie est réalisée sur la quatrième couche 124 de (Al,In,Ga)N/(Al,In,Ga)N nid ou faiblement dopé des mésas 120. Comme cette couche n'est pas porosifiée lors de l'étape d'anodisation électrochimique, elle reste continue et dense. La reprise d'épitaxie est ainsi facilitée et la couche épitaxiée présente une meilleure tenue. La création de défauts liées à la coalescence des pores est évitée.

La couche épitaxiée lors de cette étape e) est, avantageusement, en nitrure de gallium ou en nitrure d'indium et de gallium.

### Exemples comparatifs et exemples illustratifs de différents modes de réalisation :

### Exemple comparatif : augmentation de l'épaisseur de la couche à porosifier

Dans ce premier exemple réalisé à titre comparatif, l'empilement suivant a été étudié (figure 5):
- substrat 114 en saphir ou en silicium,
- couche 111 de GaN nid de 3µm d'épaisseur,
- couche 112 de GaN n à porosifier (dopage 6.10¹⁸ at/cm³) de 4µm d'épaisseur,
- couche 124 de nid-GaN de 100 nm d'épaisseur.

Des mésas de largeur L ont été formées dans l'empilement. Chaque mésa comprend une partie de la couche de GaN dopé n et la couche de nid-GaN.

L'autre partie de la couche de GaN dopé fait partie de la base de la structure.

Une structure avec des mésas de 3µm de largeur et une structure avec des mésas de 5µm de largeur ont été fabriquées.

Les contacts sont pris sur la couche de n-GaN au niveau de la base de la structure en dehors des mésas (le contact est représenté par une flèche sur la figure 5).

Puis l'étape d'anodisation est mise en oeuvre.

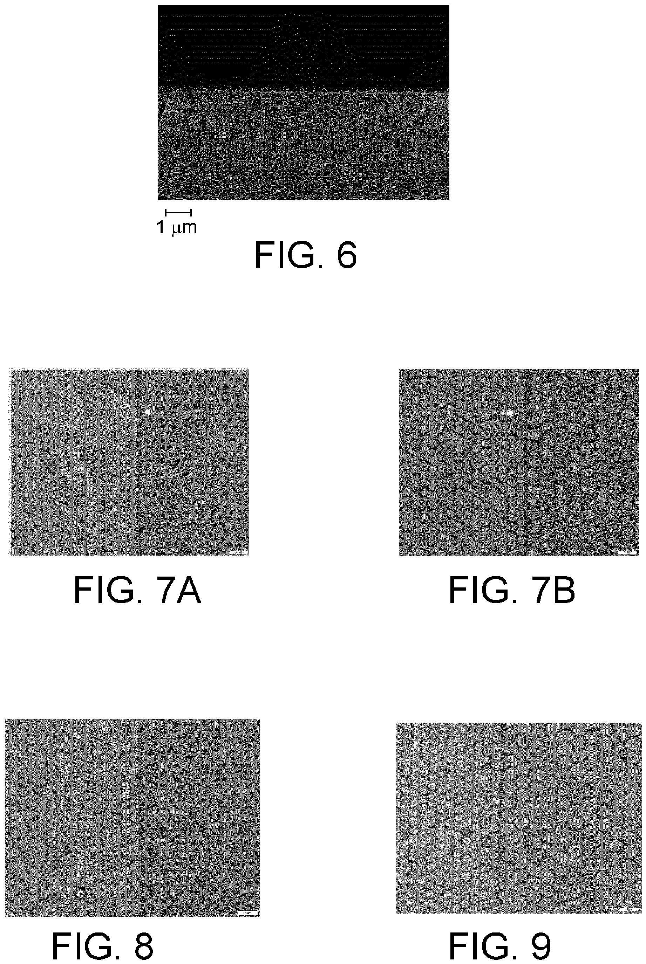

Dans cette configuration, il a été observé que la couche 112 qui sert à apporter les charges est également le siège de réactions électrochimiques de porosification. Elle perd au fur et à mesure du processus ses propriétés conductrices et la porosification des mésas s'arrête. A l'issue du procédé, les mésas ont été observées au microscope électronique à balayage (figure 6) et au microscope optique en fond noir (figures 7A et 7B) : les mésas du centre de la structure sont très partiellement porosifiées.

Afin qu'elle reste intègre, l'épaisseur (ou hauteur) de la couche 112 a été augmentée.

Il a été observé que, pour pouvoir porosifier le centre de mésas nid-GaN/nGaN (dopage de 6.10¹⁸ at/cm³), il est nécessaire de vérifier la relation : L < 2×a

En effet, si L > 2×a, la porosification se fait avec la même cinétique sur les flancs des mésas et sur la couche conductrice. Quand la couche conductrice se porosifie, elle ne peut plus alimenter les mésas et la porosification s'arrête. La mésa est partiellement porosifiée : le centre des mésas n'est pas porosifié.

Pour L < 2×a, la mésa est porosifiée entièrement mais un effet bord/centre des mésas est toujours présent. De plus, une telle configuration peut conduire à des problèmes d'intégration par rapport à l'épaisseur. En effet, pour porosifier des mésas de grande taille, la couche de contact doit être plus épaisse. Or, pour un substrat en silicium, il n'est pas possible d'avoir une épaisseur de 4µm d'épaisseur, ce qui conduit à des problèmes d'intégration.

Dans le cas de mésas GaN/InGaN, l'électrolyte s'infiltre par les défauts ('V-pits') de la couche d'InGaN. La porosification se fait à travers celle-ci, porosifiant ainsi le centre de la mésa quelle que soit les valeurs de a et L. Il est également possible d'avoir un effet bord/centre de la plaque ('wafer') avec une porosification incomplète des mésas situées au centre de plaque du fait de la dégradation de conductivité de la couche d'injection de courant pendant la polarisation électrochimique.

### 1^{er} mode de réalisation : empilement avec une couche fortement dopée

Dans ce premier mode de réalisation, comme représenté sur la figure 2A, la structure 100 à porosifier est fabriquée à partir d'un empilement comprenant successivement :
- un substrat en saphir 114,
- une première couche 111 de GaN non dopé de 4µm,
- une deuxième couche 112 de GaN dopé de 600nm (1.10¹⁸ at/cm³),
- une troisième couche 123 de GaN fortement dopé de 800nm (1,5.10¹⁹ at/cm³), et
- une quatrième couche 124 de nid (Al,In,Ga)N de 100nm.

Les mésas 120 sont formées dans la quatrième couche 124 de (Al,In,Ga)N non dopé ou faiblement dopé, la troisième couche 123 de GaN fortement dopé et une partie de la deuxième couche 112 de GaN dopé (sur une épaisseur de 100nm).

Une structure avec des mésas de 3 µm de largeur et une structure avec des mésas de 5µm de largeur ont été fabriquées. L'étape de porosification est réalisée en appliquant une tension de 9V pendant 500s (non pulsé) dans une solution d'acide oxalique (0,3M).

L'ensemble des mésas 120 d'une même plaque sont porosifiées pour des substrats de faibles ou moyennes dimensions. Cependant, pour des substrats de très grandes dimensions (typiquement supérieures ou égales à 200mm), la porosification complète de toutes les mésas d'une même plaque n'est pas assurée : celles du bord sont entièrement porosifiées, alors que celles du centre, loin de la prise de contact, ne le sont pas complètement (figure 8 ; à gauche les mésas de 3µm et à droite les mésas de 5µm).

### 2^{ème} mode de réalisation : empilement avec deux couches fortement dopées disposées de part et d'autre de la couche dopée

Dans cet autre mode de réalisation, comme représenté sur la figure 3A, la structure 100 à porosifier est fabriquée à partir d'un empilement comprenant successivement :
- un couche support en saphir 114,
- une première couche 111 de GaN non dopé de 4µm,
- une couche additionnelle 113 de GaN fortement dopé de 2µm (1,5.10¹⁹ at/cm³), dite couche enterrée,
- une deuxième couche 112 de GaN dopé de 600nm (1.10¹⁸ at/cm³),
- une troisième couche 123 de GaN fortement dopé de 800nm (1,5.10¹⁹ at/cm³), et
- une quatrième couche 124 de nid (Al,In,Ga)N de 100nm.

Les mésas 120 sont formées dans la quatrième couche de (Al,In,Ga)N non dopé ou faiblement dopé, la troisième couche 123 en (Al,In,Ga)N fortement dopé, et une partie de la deuxième couche de GaN dopé (sur une épaisseur de 100nm).

Une structure avec des mésas de 3µm de largeur et une structure avec des mésas de 5µm de largeur ont été fabriquées. L'étape de porosification est réalisée en appliquant une tension de 9V (non pulsé) dans une solution d'acide oxalique (0,9M) entre 100 et 1000s. L'arrêt du processus est contrôlé avec la chute de courant.

Avec l'ajout d'une couche fortement dopée enterrée 113, le processus de porosification est rapide et toutes les mésas d'une même plaque sont entièrement porosifiées non seulement au bord mais aussi au centre du substrat (figure 9 ; à gauche les mésas de 3µm et à droite les mésas de 5µm).

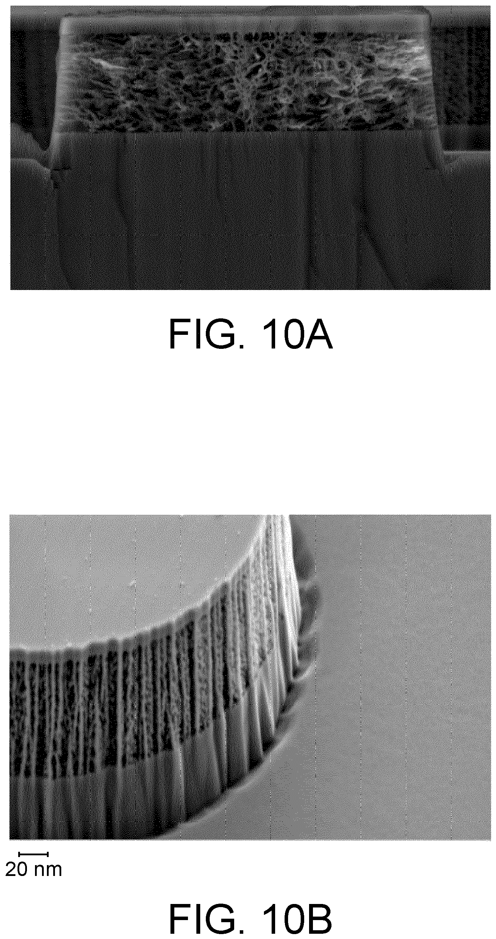

Les pieds des mésas sont intègres (figures 10A et 10B).

### Simulation des courants lors de la porosification de la structure du 2^{ème} exemple

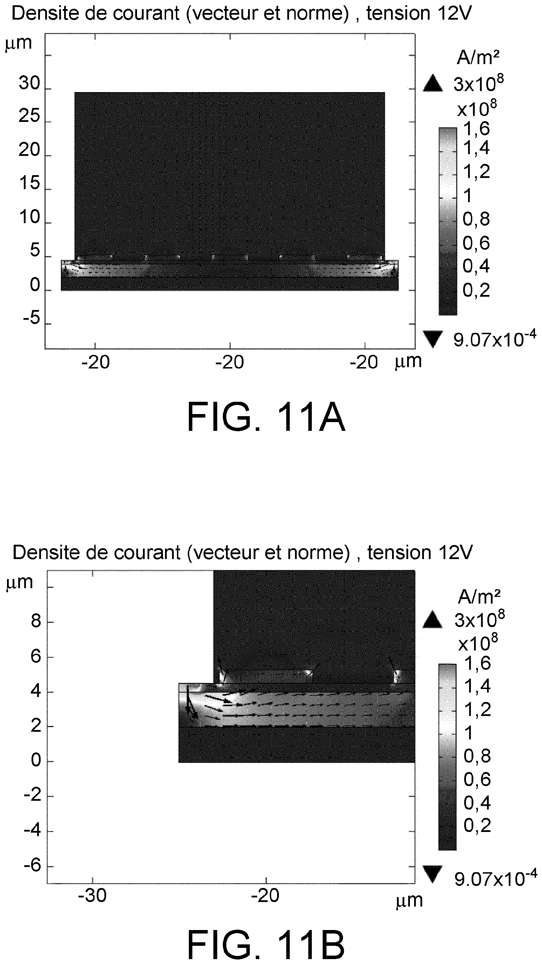

Un empilement de 50µm de diamètre a été simulé. Les empilements (épaisseurs des couches et dopage) correspondent à ceux de l'exemple 2 ci-dessus. Les mésas font 3 µm de large. La simulation confirme que le courant injecté en périphérie passe par la couche enterrée qui est plus dopée (figures 11A et 11B). Il y a ainsi une meilleure distribution du courant dans la matière.

## Revendications

1. Procédé de porosification de mésas (Al,In,Ga)N/(Al,In,Ga)N comprenant les étapes suivantes :
a) fournir une structure (100) comprenant un substrat de base (110) recouvert de mésas (120) (Al,In,Ga)N/(Al,In,Ga)N,
le substrat de base (110) comprenant :
- une couche support (114),
- une première couche (111) de GaN non dopé, disposée sur la couche support (114),
- une couche additionnelle (113) de GaN fortement dopé (113), disposée sur la première couche (111) de GaN non dopé,
- une deuxième couche (112) de GaN dopé, disposée sur la couche additionnelle (113) de GaN fortement dopé,
les mésas (120) (Al,In,Ga)N/(Al,In,Ga)N comprenant :
- une troisième couche (123) de (Al,In,Ga)N fortement dopé, et
- une quatrième couche (124) de (Al,In,Ga)N non dopé ou faiblement dopé,
une partie (112b) de la deuxième couche (112) de GaN dopé se prolongeant dans les mésas (120) ou une partie (123a) de la troisième couche (123) de (Al,In,Ga)N fortement dopé se prolongeant dans le substrat de base (110),
b) relier électriquement la structure (100) et une contre-électrode à un générateur de tension ou de courant,
c) plonger la structure (100) et la contre-électrode dans une solution électrolytique,
d) appliquer une tension ou un courant entre la structure (100) et la contre-électrode de manière à porosifier la troisième couche (123) de (Al,In,Ga)N fortement dopé des mésas (120).

2. Procédé selon la revendication 1, **caractérisé en ce que** la couche support (114) est une tranche d'au moins 10cm de diamètre et encore plus préférentiellement d'au moins 200mm de diamètre.

3. Procédé selon la revendication 1 ou 2, **caractérisé en ce que** la couche support (114) est en saphir ou en silicium.

4. Procédé selon l'une quelconque des revendications 1 à 3, **caractérisé en ce que** la quatrième couche (124) de (Al,In,Ga)N non dopé ou faiblement dopé est une couche de GaN.

5. Procédé selon l'une quelconque des revendications 1 à 4, **caractérisé en ce que** le taux de dopage de la troisième couche (123) de (Al,In,Ga)N fortement dopé et/ou le taux de dopage de la couche additionnelle (113) de GaN fortement dopé est compris entre 5.10¹⁸at/cm³ et 1,5.10¹⁹at/cm³.

6. Procédé selon l'une quelconque des revendications 1 à 5, **caractérisé en ce que** le taux de dopage de la deuxième couche (112) de GaN dopé est inférieur à 5.10¹⁸at/cm³, de préférence entre 5.10¹⁷ et 2.10¹⁸ at/cm³.

7. Procédé selon l'une quelconque des revendications 1 à 6, **caractérisé en ce que** la tension appliquée est comprise entre 3V et 15V, de préférence entre 8V et 10V.

8. Structure (100) comprenant un substrat de base (110) recouvert de mésas (120) (Al,In,Ga)N/(Al,In,Ga)N porosifiées,
le substrat de base (110) comprenant :
- une couche support (114),
- une première couche (111) de GaN non dopé, disposée sur la couche support (114),
- une couche additionnelle (113) de GaN fortement dopé, disposée sur la première couche (111) de GaN non dopé,
- une deuxième couche (112) de GaN dopé, disposée sur la couche additionnelle (113) de GaN fortement dopé,
les mésas (120) (Al,In,Ga)N/(Al,In,Ga)N comprenant :
- une troisième couche (123) de GaN fortement dopé porosifié, et
- une quatrième couche (124) de (Al,In,Ga)N non dopé ou faiblement dopé,
une partie (112b) de la deuxième couche (112) de GaN dopé se prolongeant dans les mésas (120) ou une partie (123a) de la troisième couche (123) de (Al,In,Ga)N fortement dopé se prolongeant dans le substrat de base (110).

9. Structure selon la revendication 8, **caractérisée en ce que** la quatrième couche (124) de (Al,In,Ga)N non dopé ou faiblement dopé est une couche de GaN et/ou **en ce que** la couche support (114) est une tranche d'au moins 200mm de diamètre.
